# EUROPEAN PATENT SPECIFICATION

(11) **EP 3 968 401 B1**
(45) Date of publication and mention of the grant of the patent: **17.01.2024**
(21) Application number: 21196035.6
(22) Date of filing: 10.09.2021
(51) Int. Cl.: H10N 70/20, H10N 70/00, G11C 13/00, G11C 11/56

(54) **SYSTEM AND DEVICE INCLUDING MEMRISTOR MATERIAL**
SYSTEM UND VORRICHTUNG MIT EINEM MEMRISTOR-MATERIAL
SYSTÈME ET DISPOSITIF COMPRENANT UN MATÉRIAU DE MEMRISTANCE

(30) Priority: 10.09.2020 US 202017017313; 10.09.2020 US 202017017365; 07.12.2020 US 202017113406; 07.12.2020 US 202017113329
(43) Date of publication of application: 16.03.2022
(73) Proprietor: Rockwell Collins, Inc., Cedar Rapids, IA 52498 (US)
(72) Inventor: SNYDER, Kyle B., Marion, IA (US); WYCKOFF, Nathaniel P., Marion, IA (US); HAMILTON, Brandon C., Marion, IA (US); ROWENHORST, Bruce E., Marion, IA (US); WIEBERS, Steven J., Center Point, IA (US)
(74) Representative: Dehns

(56) References cited:
- WO-A1-2015/183291
- WO-A1-2016/064404
- US-A1- 2012 026 776
- US-A1- 2012 176 831

## Description

### CROSS-REFERENCE TO RELATED APPLICATIONS

The present application is related to: United States Application Serial Number 17/017,313, titled SYSTEM AND DEVICE INCLUDING MEMRISTOR MATERIAL, filed September 10, 2020; United States Application Serial Number 17/017,365, titled SYSTEM AND DEVICE INCLUDING MEMRISTOR MATERIAL, filed September 10, 2020; and United States Application Serial Numbers 17/113,329 and 17/113,406 titled SYSTEM AND DEVICE INCLUDING MEMRISTOR MATERIAL, filed 7 December 2020.

### BACKGROUND

Memristors have been the subject of discussion and research, but have not been used in many commercial applications. US 2012/176831 relates to a resistive random access memory with a low current option. WO 2015/183291 relates to memory controllers. WO20160644404 discloses a memristor array controlled by a single controller that includes a number of first memristors having a first set of logic indicators and a number of second memristors having a second set of logic indicators and US2012026776 relates to a two-by-two array with memristors steered by a memristor memory array controller.

### SUMMARY

In one aspect, embodiments of the inventive concepts disclosed herein are directed to a system, as defined in claim 1.

In a further aspect, embodiments of the inventive concepts disclosed herein are directed to a method, as defined in claim 8.

### BRIEF DESCRIPTION OF THE DRAWINGS

Implementations of the inventive concepts disclosed herein may be better understood when consideration is given to the following detailed description thereof. Such description makes reference to the included drawings, which are not necessarily to scale, and in which some features may be exaggerated and some features may be omitted or may be represented schematically in the interest of clarity. Like reference numerals in the drawings may represent and refer to the same or similar element, feature, or function. In the drawings:
FIG. 1A is a view of an exemplary embodiment of a system including a memristor according to the inventive concepts disclosed herein.
FIG. 1B is a view of an exemplary embodiment of the system of FIG. 1A including a memristor according to the inventive concepts disclosed herein.
FIG. 1C is a view of an exemplary embodiment of the system of FIG. 1A including a memristor according to the inventive concepts disclosed herein.
FIG. 1D is a view of an exemplary embodiment of the system of FIG. 1A including a memristor according to the inventive concepts disclosed herein.
FIG. 2 is an exemplary embodiment of a memristor according to the inventive concepts disclosed herein.
FIG. 3 is an exemplary embodiment of a memristor according to the inventive concepts disclosed herein.
FIG. 4 is an exemplary embodiment of a memristor according to the inventive concepts disclosed herein.
FIG. 5 is an exemplary graph according to the inventive concepts disclosed herein.
FIG. 6 is an exemplary graph according to the inventive concepts disclosed herein.
FIG. 7 is an exemplary embodiment of a memristor according to the inventive concepts disclosed herein.
FIG. 8 is an exemplary graph according to the inventive concepts disclosed herein.
FIG. 9 is an exemplary embodiment of a memristor according to the inventive concepts disclosed herein.
FIG. 10 is an exemplary graph according to the inventive concepts disclosed herein.
FIG. 11 is an exemplary embodiment of a memristor according to the inventive concepts disclosed herein.
FIG. 12 is an exemplary graph according to the inventive concepts disclosed herein.
FIG. 13 is an exemplary embodiment of a memristor according to the inventive concepts disclosed herein.
FIG. 14 is an exemplary embodiment of a device according to the inventive concepts disclosed herein.
FIG. 15 is an exemplary embodiment of a memristor according to the inventive concepts disclosed herein.
FIG. 16 is an exemplary embodiment of a memristor according to the inventive concepts disclosed herein.
FIG. 17 is an exemplary graph according to the inventive concepts disclosed herein.
FIG. 18 is an exemplary embodiment of a memristor according to the inventive concepts disclosed herein.
FIG. 19 is an exemplary graph according to the inventive concepts disclosed herein.
FIG. 20 is a diagram of an exemplary embodiment of a method according to the inventive concepts disclosed herein.
FIG. 21 is a diagram of an exemplary embodiment of a method according to the inventive concepts disclosed herein.
FIG. 22 is a view of an exemplary embodiment of the system of FIG. 1A including multi-lead memristors according to the inventive concepts disclosed herein.
FIG. 23 is an exemplary embodiment of a 2D array of interconnected memristors of FIG. 22 according to the inventive concepts disclosed herein.
FIG. 24 is a side view of an exemplary embodiment of a 1D or 2D array of interconnected memristors of FIG. 22 according to the inventive concepts disclosed herein.
FIG. 25 is a top view of an exemplary embodiment of a 1D array of interconnected memristors of FIG. 22 according to the inventive concepts disclosed herein.
FIG. 26 is a top view of an exemplary embodiment of a 2D array of interconnected memristors of FIG. 22 according to the inventive concepts disclosed herein.
FIG. 27 is a view of an exemplary embodiment of the system of FIG. 22 including multi-lead memristors according to the inventive concepts disclosed herein.
FIG. 28 is a diagram of an exemplary embodiment of a method according to the inventive concepts disclosed herein.

### DETAILED DESCRIPTION

Before explaining at least one embodiment of the inventive concepts disclosed herein in detail, it is to be understood that the inventive concepts are not limited in their application to the details of construction and the arrangement of the components or steps or methodologies set forth in the following description or illustrated in the drawings. In the following detailed description of embodiments of the instant inventive concepts, numerous specific details are set forth in order to provide a more thorough understanding of the inventive concepts. However, it will be apparent to one of ordinary skill in the art having the benefit of the instant disclosure that the inventive concepts disclosed herein may be practiced without these specific details. In other instances, well-known features may not be described in detail to avoid unnecessarily complicating the instant disclosure. The inventive concepts disclosed herein are capable of other embodiments or of being practiced or carried out in various ways. Also, it is to be understood that the phraseology and terminology employed herein is for the purpose of description and should not be regarded as limiting.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only, and should not be construed to limit the inventive concepts disclosed herein in any way unless expressly stated to the contrary.

Further, unless expressly stated to the contrary, "or" refers to an inclusive or and not to an exclusive or. For example, a condition A or B is satisfied by anyone of the following: A is true (or present) and B is false (or not present), A is false (or not present) and B is true (or present), and both A and B are true (or present).

In addition, use of the "a" or "an" are employed to describe elements and components of embodiments of the instant inventive concepts. This is done merely for convenience and to give a general sense of the inventive concepts, and "a" and "an" are intended to include one or at least one and the singular also includes the plural unless it is obvious that it is meant otherwise.

Finally, as used herein any reference to "one embodiment," or "some embodiments" means that a particular element, feature, structure, or characteristic described in connection with the embodiment is included in at least one embodiment of the inventive concepts disclosed herein. The appearances of the phrase "in some embodiments" in various places in the specification are not necessarily all referring to the same embodiment, and embodiments of the inventive concepts disclosed may include one or more of the features expressly described or inherently present herein, or any combination of sub-combination of two or more such features, along with any other features which may not necessarily be expressly described or inherently present in the instant disclosure.

Broadly, embodiments of the inventive concepts disclosed herein are directed to a method and a system including at least one device (e.g., at least one memristor) having at least one memristor material.

In some embodiments, for a memristor element, a desired signal response can be achieved by using (e.g., modifying) at least one particular material (e.g., at least one memristor material) as a transmission medium. In some embodiments, the signal response of the memristor can be modified by controlling an oxygen vacancy transmission rate of the at least one particular material. For example, controlling the oxygen vacancy transmission rate of the at least one particular material can be achieved by a physical modification and/or a chemical modification. In some embodiments, the signal response can provide an asymmetric time based response (e.g., a homogenous asymmetric time based response and/or a compartmentalized asymmetric time based response).

Some embodiments may allow memristor characteristics to be tuned (e.g., tuned in real time during operation) to meet system design needs. Some embodiments may allow memristor elements to be tuned (e.g., additively tuned) around application specific integrated circuit (ASIC) circuitry, sometimes referred to as trimming. Some embodiments may provide circuit modification (e.g., additive circuit modification) of a memristor to improve ASIC shortcomings. Some embodiments may include tuning (e.g., additively tuning) memristor components to address timing specific needs of signal lines (e.g., key signal lines). For example, some embodiments may allow for custom signal optimization to account for a build process of circuit variance.

Some embodiments may include physically changing an order and configuration of memristor structures to develop features with unique electrical responses. For example, by controlling a geometry of a medium that is passing a signal, a movement and effect of oxygen vacancies can be controlled so as to modify a response temporarily or permanently. Such responses can inhibit an asymmetric response, a permanent penalty associated with drive direction, a time based response modification, and/or a combination thereof.

Some embodiments may allow for a potential to provide an element of repeatable uniqueness for use in anti-counterfeiting of electronic devices. Some embodiments may facilitate a generation of behavior based response techniques. Some embodiments may be useful for applications that need unique but repeatable responses (e.g., a unique fingerprint). Some embodiments may provide authenticity validation through unique but repeatable electrical responses.

Some embodiments may include at least one filter (e.g., a high pass filter and/or a low pass filter), which may include at least one memristor instead of a capacitor.

Some embodiments may include an array of memristors, which may be tunable.

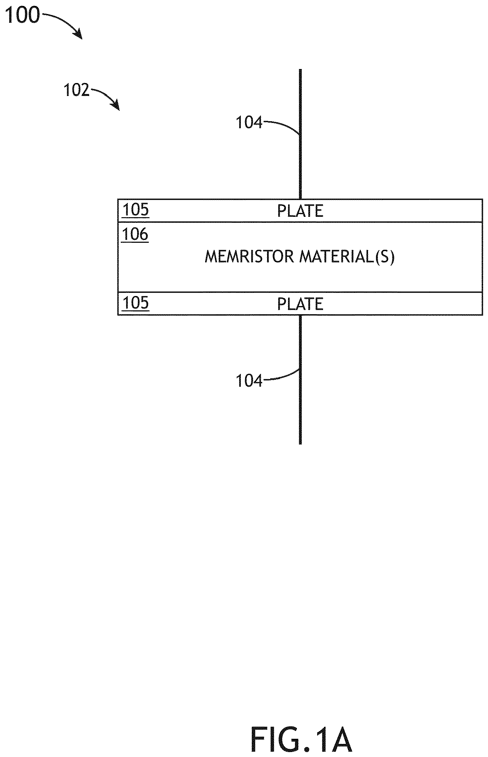

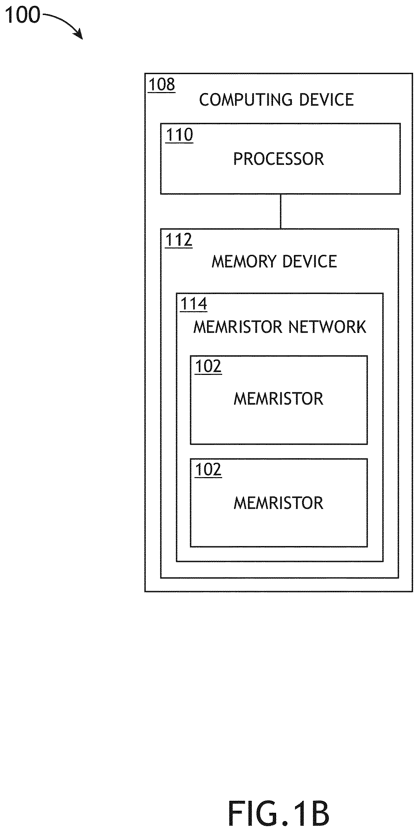

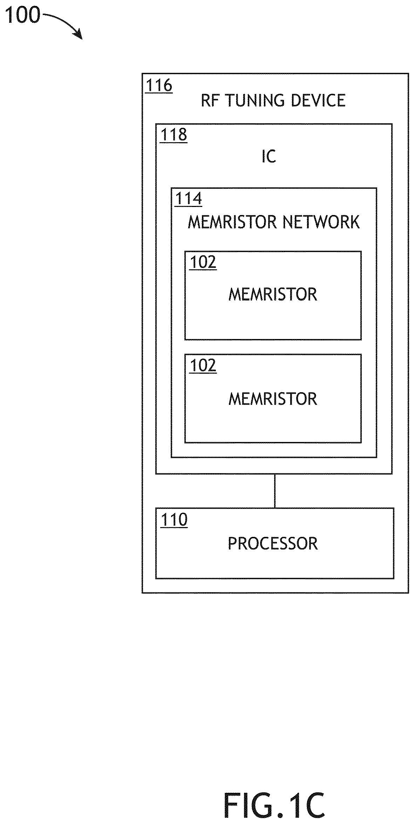

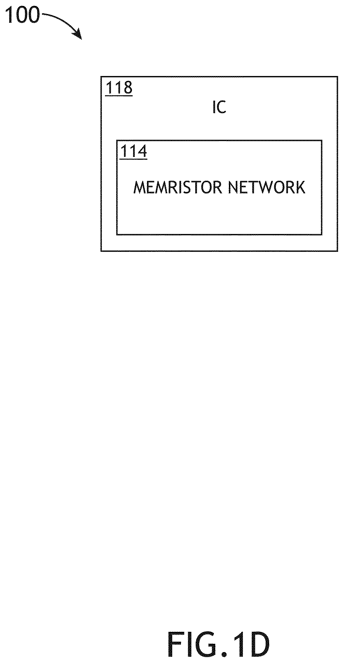

Referring now to FIGS. 1A, 1B, 1C, and 1D, exemplary embodiments of a system 100 according to the inventive concepts disclosed herein are depicted. The system 100 may be implemented as any suitable system, such as at least one vehicle system (e.g., at least one aircraft, at least one watercraft, at least one submersible craft, at least one automobile, and/or at least one train), a communication system, an optical system, a computing device system, a multiple computing device system, a radiofrequency (RF) device system, and/or a multiple RF device system.

For example, as shown in FIG. 1A, the system 100 may include at least one device (e.g., at least one memristor 102) including at least two terminals 104, at least two conductive plates 105, and/or at least one memristor material 106. Some or all of the at least one memristor 102 and/or any other components of the system 100 may be communicatively coupled at any given time. Some embodiments may include multiple memristors 102 implemented as a memristor network 114 (as shown in FIGS. 1B-1D). For example, the memristor network 114 may include a plurality of at least partially communicatively coupled (e.g., at least partially interconnected) memristors 102 that may be arranged in an array, in parallel, and/or in series. In some embodiments, the at least one memristor 102 may be fabricated on an integrated circuit (IC) device (e.g., IC 118, as shown in FIGS. 1C-1D). In some embodiments, the at least one memristor 102 may be part of a memory device (e.g., 112, as shown in FIG. 1B).

For example, a first conductive plate 105 may be configured at least to receive an input signal via a first terminal 104; and a second conductive plate 105 may be configured at least to output an output signal via a second terminal 104. For example, the at least one memristor material 106 may be positioned between the first conductive plate 105 and the second conductive plate 105.

In some embodiments, the at least one memristor material 106 may be composed of any suitable memristor material, such as any suitable ionic-covalent metal compound. For example, each of the at least one memristor material 106 may comprise at least one of: at least one metal oxide (e.g., TiO₂, ZrO₂, NiO, CuO, CoO, Fe₂O₃, MoO, VO₂, and/or HfO₂), at least one metal sulfide, at least one metal selenide, at least one metal telluride, at least one metal nitride, at least one metal phosphite, and/or at least one metal arsenide. TiO₂, ZrO₂, NiO, CuO, CoO, Fe₂O₃, MoO, VO₂, and HfO₂ are known in the art to be suitable memristor materials. Each memristor material 106 may have oxygen vacancy and/or anion vacancy characteristics. Oxygen vacancy refers to a point defect in a crystal or glass where an oxygen ion is missing at an expected lattice or structure position, which results in a net positive charge, a trapped electron, and a metastable atomic structure. Anion vacancy refers to a point defect in a crystal or glass where an anion ion is missing at an expected lattice or structure position, which results in a net positive charge, a trapped electron, and a metastable atomic structure.

For example, as shown in FIG. 1B, the system 100 may include at least one computing device 108. If the system 100 includes multiple computing devices 108, some or all of the computing devices 108 may be communicatively coupled at any given time.

In some embodiments, the computing device 108 may include at least one processor 110 and/or at least one memory device 112, some or all of which may be communicatively coupled at any given time. In some embodiments, each of the processor 110 and/or the memory device 112 may include at least one circuit (e.g., at least one IC 118, as shown in FIGS. 1C-1D).

The at least one processor 110 may be implemented as any suitable type and number of processors. For example, the at least one processor 110 may include at least one general purpose processor (e.g., at least one central processing unit (CPU)), at least one digital signal processor (DSP), at least one application specific integrated circuit (ASIC), at least one field-programmable gate array (FPGA), at least one complex programmable logic device (CPLD), and/or at least one graphics processing unit (GPU). The at least one processor 110 may be configured to perform (e.g., collectively perform if more than one processor) any or all of the operations disclosed throughout. The processor 110 may be configured to run various software and/or firmware applications and/or computer code stored (e.g., maintained) in a non-transitory computer-readable medium (e.g., memory device 112) and configured to execute various instructions or operations. For example, the at least one processor 110 may be configured to: output a signal; receive a signal; output data to the memory device 112; receive data from the memory device 112; determine and/or use a signature of a received signal; perform anti-piracy operations based at least on the signature; perform cyber security authentication operations based at least on the signature; perform unique data storage operations based at least on the signature; perform usage temperature authentication operations based at least on the signature; cause a barrier material to be fused; and/or cause an activation of at least one of a blocking material, a permanent modification material, or a transfer rate modification material.

The memory device 112 may include the at least one memristor 102, which may be implemented as the memristor network 114 if more than one memristor 102. For example, the memory device 112 may be a non-volatile and/or persistent memory device. For example, the memory device 112 may be configured to: store data; read data; write data; output data; receive data; receive input signals; output signals; determine and/or use a signature of a received signal; perform anti-piracy operations based at least on the signature; perform cyber security authentication operations based at least on the signature; perform unique data storage operations based at least on the signature; perform usage temperature authentication operations based at least on the signature; cause a barrier material to be fused; and/or cause an activation of at least one of a blocking material, a permanent modification material, or a transfer rate modification material

For example, as shown in FIG. 1C, the system 100 may include at least one RF tuning device 116. If the system 100 includes multiple RF tuning devices 116, some or all of the RF tuning devices 116 may be communicatively coupled at any given time.

In some embodiments, the RF tuning device 116 may include at least one processor 110, at least one IC 118, and/or at least one memory device 112, some or all of which may be communicatively coupled at any given time. In some embodiments, each of the processor 110, the IC 118, and/or the memory device 112 may include at least one circuit (e.g., at least one IC 118, as shown in FIGS. 1C-1D). The RF tuning device 116 may be configured to tune RF signal outputs.

The at least one processor 110 may be implemented similarly and function similarly to the processor 110 shown in FIG 1B, except that the at least one processor 110 may be further configured to cause RF tuning operations to be performed.

The IC 118 may include the at least one memristor 102, which may be implemented as the memristor network 114 if more than one memristor 102. The at least one IC 118 may be configured to perform (e.g., collectively perform if more than one IC) any or all of the operations disclosed throughout. The IC 118 may be configured to run various software and/or firmware applications and/or computer code stored (e.g., maintained) in a non-transitory computer-readable medium (e.g., memory device 112) and configured to execute various instructions or operations. For example, the IC 118 may be configured to: output a signal; receive a signal; output data to the memory device 112; receive data from the memory device 112; determine and/or use a signature of a received signal; perform anti-piracy operations based at least on the signature; perform cyber security authentication operations based at least on the signature; perform unique data storage operations based at least on the signature; perform usage temperature authentication operations based at least on the signature; cause a barrier material to be fused; cause an activation of at least one of a blocking material, a permanent modification material, or a transfer rate modification material; and/or perform RF signal tuning operations.

For example, as shown in FIG. 1D, the system 100 may include at least one circuit (e.g., at least one IC 118). If the system 100 includes multiple ICs 118, some or all of the ICs 118 may be communicatively coupled at any given time. The at least one IC 118 may be implemented similarly and function similarly to the IC 118 shown in and described with respect to FIG. 1C.

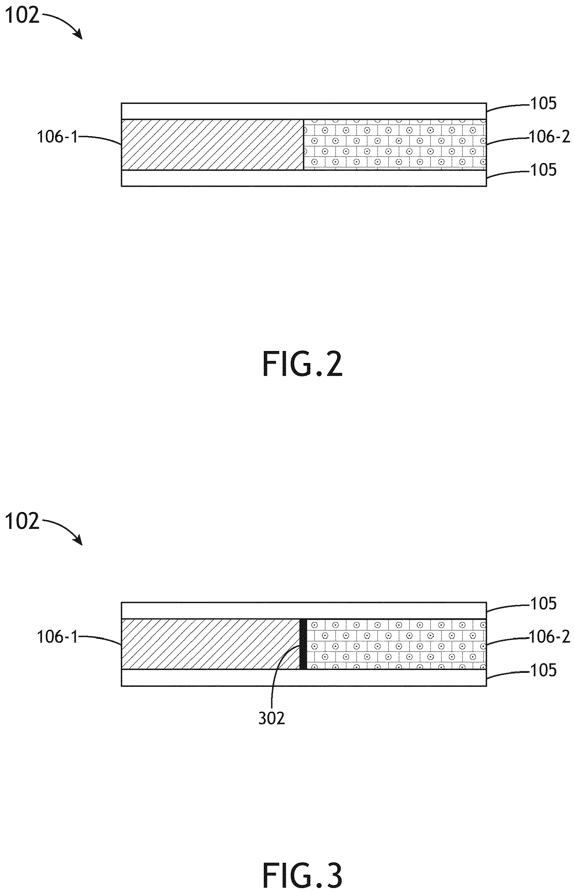

Referring now to FIGS. 2-6, exemplary embodiments of the system 100 including at least one memristor 102 according to the inventive concepts disclosed herein are depicted.

Referring now to FIG. 2, an exemplary embodiment of at least one memristor 102 according to the inventive concepts disclosed herein is depicted.

For example, the memristor 102 may include a first conductive plate 105 configured at least to receive an input signal, a second conductive plate 105 configured at least to output an output signal, and at least two memristor materials (e.g., a first memristor material 106-1 and a second memristor material 106-2). The first memristor material 106-1 may be positioned between the first conductive plate 105 and the second conductive plate 105. The second memristor material 106-2 may be positioned between the first conductive plate 105 and the second conductive plate 105. The first memristor material 106-1 and the second memristor material 106-2 may be in parallel electrically. The first memristor material 106-1 may be different from the second memristor material 106-2. For example, the first memristor material 106-1 may be a relatively slower or faster response material than the second memristor material 106-2. Memristor response may depend on the crystal chemistry, crystal phase, the amount of underproportination and disproportionation, etc. Memristor response may be influenced by the cation-anion bond strength and the cation-anion size ratio. The responsiveness of the memristor materials 106 can be measured. In some embodiments, the responsiveness of the memristor materials 106 can be approximated by Gibbs Free Energy of Formation since Gibbs Free Energy of Formation incorporates several energy well/barrier type quantities. Based on approximated responsiveness using Gibbs Free Energy of Formation, some examples of memristor materials 106 ordered from relatively slower approximated responsiveness to relatively faster approximated responsiveness are: Ti₂O₃ at - 11,133,903 ΔGf° (kJ/mol); TazOs at -1,910,984 ΔGf° (kJ/mol); Sc₂O₃ at -1,819,371 ΔGf° (kJ/mol); Nb₂O₅ at -1,765,859 ΔGf° (kJ/mol); TiO₂ (Rutile) at -889,446 ΔGf° (kJ/mol); TiO₂ (Anatase) at -883,303 ΔGf° (kJ/mol); NbO₂ at -739,194 ΔGf° (kJ/mol); MgO at -569,196 ΔGf° (kJ/mol); and NbO at -391,945 ΔGf° (kJ/mol).

In some embodiments, the first memristor 106-1 material has a first current-voltage (I-V) curve, the second memristor material 106-2 has a second I-V curve, and the memristor 102 has a third I-V curve, wherein each of the first, second, and third I-V curves are different. For example, as shown in FIG. 2, the third I-V curve is indicative of an asymmetric time-based response (e.g., a homogenous asymmetric time-based response). In some embodiments, the output signal of the memristor 102 may have a signature based at least on the asymmetric time-based response. For example, the signature may be at least semi-unique (e.g., unique, unique to a product, or unique to a manufacturer) and/or may be indicative of at least one of an identity or an authenticity of an electronic component or device. In some embodiments a circuit (e.g., an IC 118) may be configured to receive and use the signature of the output signal for at least one of: anti-piracy, cyber security authentication, unique data storage, electronic serialization, or usage temperature authentication (e.g., by fusing the barrier material 302). For example, the signature can be achieved by strategically selection of the at least two memristor materials (e.g., 106-1, 106-2), dimensions of the at least two memristor materials (e.g., 106-1, 106-2), and/or an arrangement of the at least two memristor materials (e.g., 106-1, 106-2). For example, the signature may be used as an identification feature for part authentication.

Referring now to FIG. 3, an exemplary embodiment of at least one memristor 102 according to the inventive concepts disclosed herein is depicted.

For example, the memristor 102 may be implemented similarly and function similarly to the memristor of FIG. 2, except that the memristor 102 of FIG. 3 may include at least one barrier material 302.

For example, the barrier material 302 may extend from the first conductive plate 105 to the second conductive plate 105. The barrier material 302 may be positioned between the first memristor material 106-1 and the second memristor material 106-2 such that the first memristor material 106-1 is not in contact with the second memristor material 106-2. In some embodiments, the barrier material 302 may be a fuse configured to permanently configure the memristor 102, for example, that may be activated thermally. For example, some embodiments of suitable barrier materials may include any noble metal (e.g., Au, Pt, Ag, Ir, Rh, Ru, Pd, and/or Os), highly covalently bonded material (e.g., carbon allotropes, silicon allotropes, Ge, Te, and/or Se, etc...), mostly elemental forms of nonmetals and metalloids which form solids at standard temperature and pressure (STP) for periodic table groups 14, 15, and 16, or some combination thereof.

In some embodiments, the first memristor 106-1 material has a first current-voltage (I-V) curve, the second memristor material 106-2 has a second I-V curve, and the memristor 102 has a third I-V curve, wherein each of the first, second, and third I-V curves are different. For example, as shown in FIG. 2, the third I-V curve is indicative of an asymmetric time-based response (e.g., a compartmentalized asymmetric time-based response). In some embodiments, the output signal of the memristor 102 may have a signature based at least on the asymmetric time-based response. For example, the signature may be at least semi-unique (e.g., unique, unique to a product, or unique to a manufacturer) and/or may be indicative of at least one of an identity or an authenticity of an electronic component or device. In some embodiments, a circuit (e.g., an IC 118) may be configured to receive and use the signature of the output signal for at least one of: anti-piracy, cyber security authentication, unique data storage, electronic serialization, or usage temperature authentication (e.g., by fusing the barrier material 302). For example, the signature can be achieved by strategic selection of the at least two memristor materials (e.g., 106-1, 106-2), dimensions of the at least two memristor materials (e.g., 106-1, 106-2), and/or an arrangement of the at least two memristor materials (e.g., 106-1, 106-2). For example, the signature may be used as an identification feature for part authentication.

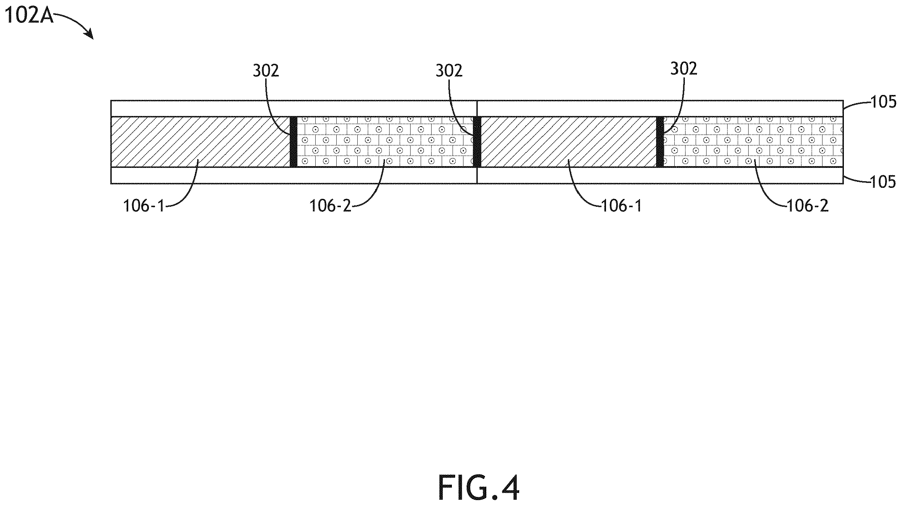

Referring now to FIG. 4, an exemplary embodiment of at least one memristor 102 according to the inventive concepts disclosed herein is depicted.

For example, the memristor 102 may be implemented similarly and function similarly to the memristor of FIG. 2 and/or 3, except that the memristor 102 of FIG. 4 may include at least two of the first memristor material 106-1, at least two of the second memristor material 106-2, and at least two barrier material 302. For example, the first memristor material 106-1 sections, the second memristor material 106-2 sections, and barrier material 302 sections may be interspersed (e.g., in one dimension or two dimensions (e.g., in a two-dimensional array)). In some embodiments, one or more of the barrier material 302 sections may be omitted. In some embodiments, the memristor 102 may include more than one (e.g., two, three, four, or more) type of memristor material 106.

Referring to FIGS. 3-4, in some embodiments, the barrier material 302 may be used to permanently change the memristor 102. For example, the barrier material 302 may be used to permanently change a phase of the memristor 102.

For example, the barrier material 302 may be used to permanently configure the memristor 102, for example, to set the memristor 102 to a known value. For example, the barrier material 302 may be activated thermally and act as a fusing structure. In some embodiments, different materials for the memristor materials 106-1, 106-2 and/or the barrier material(s) 302 may be used to control a speed of and an amount of oxygen depletion transfer.

In some embodiments, memristors 102 may be arranged in an array as a memristor network 114. For example, the memristor network 114 (e.g., which may be implemented in the RF tuning device 116) may be used for configuring test values (e.g., resistance values). For example, the memristor network 114 may be used to tune a circuit (e.g., an IC 118, such as an ASIC) by trimming resistance values (e.g., by using test selects). For example, the memristor network 114 may be used to tune a resistor-capacitor (RC) circuit delay. For example, such tuning may be similar to how mixed signals circuits are tuned by swapping resistors after a characterization test is complete, then retesting for proper performance. In some embodiments, the memristor network 114 may be configured as multiple interconnected memristors 102 or as a single memristor 102 having multiple fuseable barrier materials 302. In some embodiments, one memristor 102 of the memristor network 114 may influence another memristor 102 of the memristor network 114, for example, based on a fusing of a barrier material 302.

In some embodiments, at least one memristor 102 having at least one barrier material 302 may be used in the memory device 112 (e.g., a non-volatile memory device).

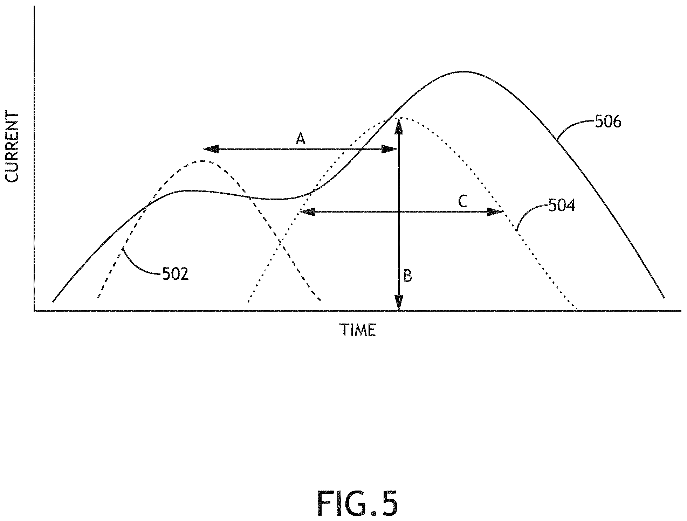

Referring now to FIG. 5, an exemplary graph of current versus time is shown. The graph shows a first curve 502, a second curve 504, and a third curve 506. The first curve 502 demonstrates a responsiveness of the first memristor material 106-1. The second curve 504 demonstrates a responsiveness of the second memristor material 106-2. The third curve 506 demonstrates a responsiveness of the memristor 102 having the first memristor material 106-1 and the second memristor material 106-2. The third curve 506 may be indicative of an asymmetric time-based response (e.g., a homogenous asymmetric time-based response and/or a compartmentalized asymmetric time-based response) that may be associated with a signature as discussed herein.

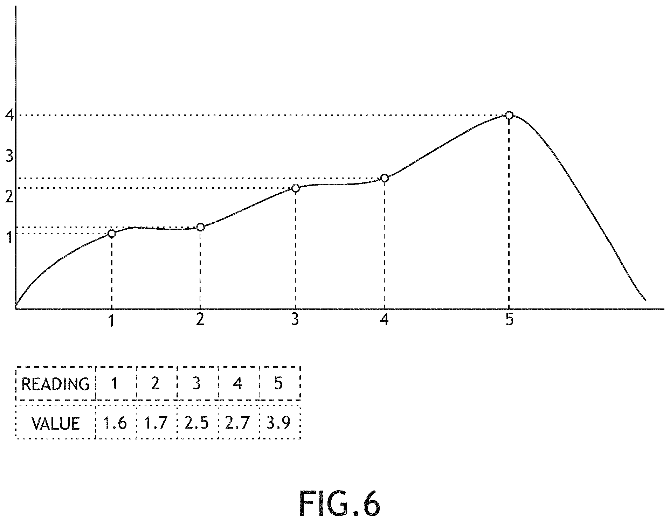

Referring now to FIG. 6, an exemplary graph of current versus time for a memristor 102 is shown. For example, values of the output current for the memristor 102 can be read at various times (e.g., 5 times, as shown). The combination of the values read at different times can be used as a signature as discussed herein.

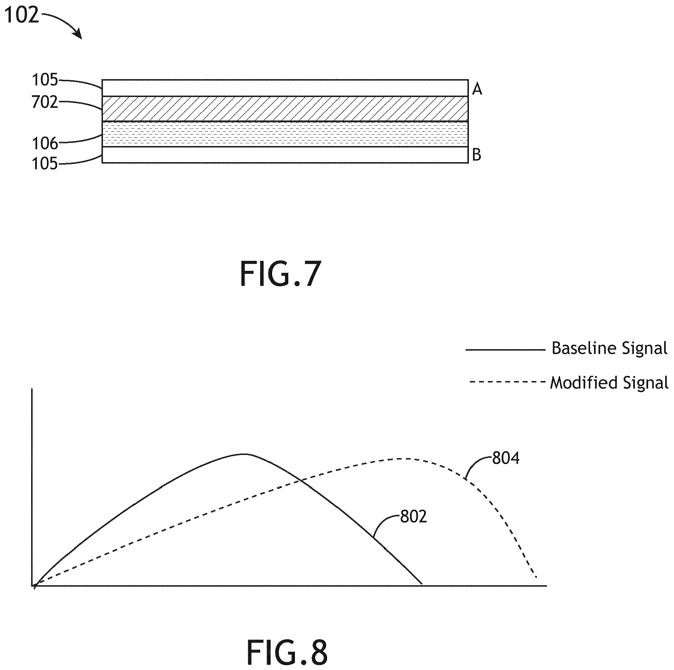

Referring now to FIGS. 7-19, exemplary embodiments of the system 100 including at least one memristor 102 according to the inventive concepts disclosed herein are depicted. Each memristor 102 may include at least one blocking material 602, at least one permanent modification material 902, and/or at least one transfer rate modification material 702.

In some embodiments, a blocking material 602 may be any suitable material that does not permit transmission of a memristor charge carrying mechanism. Some examples of suitable blocking materials 602 include gold (Au), platinum (Pt), and/or palladium (Pd).

In some embodiments, a permanent modification material 902 may be any suitable material that absorbs memristor charge carriers. An example may be a cation oxidation number change that results in absorption or generation of total oxygen vacancies. Some examples of suitable permanent modification materials 902 may include a metal oxide (e.g., a metal oxide near the surface of the electrode whose cation is reduced to its metallic form and whose anion fills the oxygen vacancy), such as a noble metal oxide.

In some embodiments, a transfer rate modification material 702 may be any suitable material that changes a transmission rate of memristor charge carriers. An example may be a transient or residual crystallographic phase change which results in a change in oxygen vacancy transmission rate. For example, a transfer rate modification material 702 may be implemented by depositing a material in a metastable crystal phase or glassy phase (which may be inherently metastable) such that a thermal or optical stimulus initiates a phase shift to the more stable phase at the usage temperature. Depositing in a metastable phase can be accomplished by modifying the deposition rate, substrate biasing, and/or deposition pressure. Since the oxygen vacancy conduction rate is dependent on the crystal phase, the memristor response will be different after the phase transformation. In some embodiments, for such an example, TiO2 in Rutile and Anatase may have a different memristor response since the bond strength is different and the crystal geometry is different. Additionally, for example, a transfer rate modification material 702 may be implemented by depositing a material that has a crystal phase transition over the operation temperature. In this embodiment the memristor response would change discontinuously at the temperature where the crystal phase changes. For example, VO₂ has a monoclinic to tetragonal crystal phase transition around 67 degrees Celsius and may be a suitable transfer rate modification material 702.

Referring now to FIG. 7, an exemplary embodiment of at least one memristor 102 according to the inventive concepts disclosed herein is depicted. The memristor 102 may be implemented similarly and function similarly to the memristor 102 of FIG. 1A, except that the memristor 102 of FIG. 7 may include at least one transfer rate modification material 702.

In some embodiments, the transfer rate modification material 702 may be positioned between the first conductive plate 105 and the second conductive plate 105. At least a portion of the transfer rate modification material 702 may abut the memristor material 106. The transfer rate modification material 702 may provide a shift in a stabilization time to the output signal after a signal is driven from the second conductive plate 105 (B) to the first conductive plate 105 (A).

Referring now to FIG. 8, an exemplary graph of current versus time is shown. The graph shows a first curve 802 and a second curve 804. The first curve 802 is associated with a baseline signal (e.g., an unmodified signal) before activation of the transfer rate modification material 702. The second curve 804 is associated with a modified signal after activation of the transfer rate modification material 702. For example, this modification may result in a modified output signal from the first conductive plate 105 (A) to the second conductive plate 105 (B).

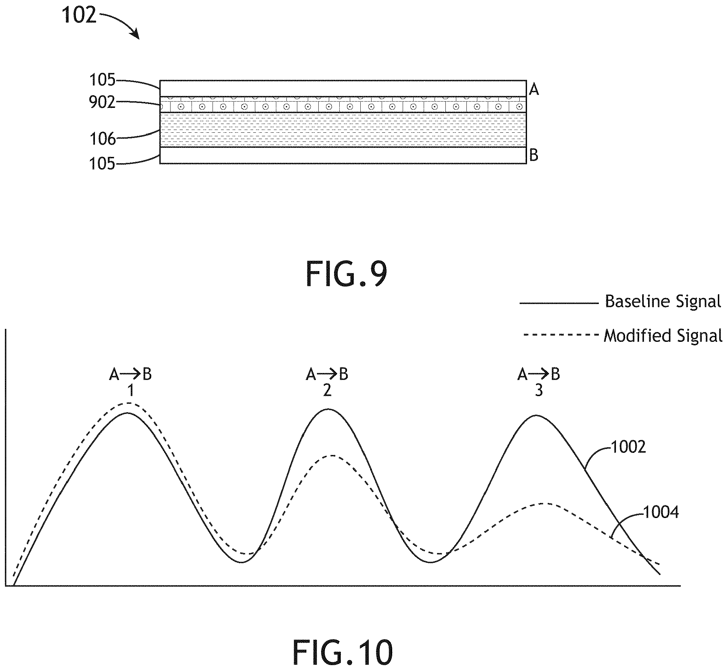

Referring now to FIG. 9, an exemplary embodiment of at least one memristor 102 according to the inventive concepts disclosed herein is depicted. The memristor 102 may be implemented similarly and function similarly to the memristor 102 of FIG. 1A, except that the memristor 102 of FIG. 9 may include at least one permanent modification material 902.

In some embodiments, the permanent modification material 902 may be positioned between the first conductive plate 105 and the second conductive plate 105. At least a portion of the permanent modification material 902 may abut the memristor material 106. The permanent modification material 902 may provide a permanent signal modification (e.g., a permanent uniform signal modification) to the output signal after a signal is driven from the second conductive plate 105 (B) to the first conductive plate 105 (A). For example, this modification may result in a modified output signal from the first conductive plate 105 (A) to the second conductive plate 105 (B). Each subsequent activation (e.g., by driving a signal from the second conductive plate 105 (B) to the first conductive plate 105 (A)) of the permanent modification material 902 may compound modification effects.

Referring now to FIG. 10, an exemplary graph of current versus time is shown. The graph shows a first curve 1002 and a second curve 1004. The first curve 1002 is associated with a baseline signal (e.g., an unmodified signal) before activation of the permanent modification material 902. The second curve 1004 is associated with a modified signal after activation of the permanent modification material 902.

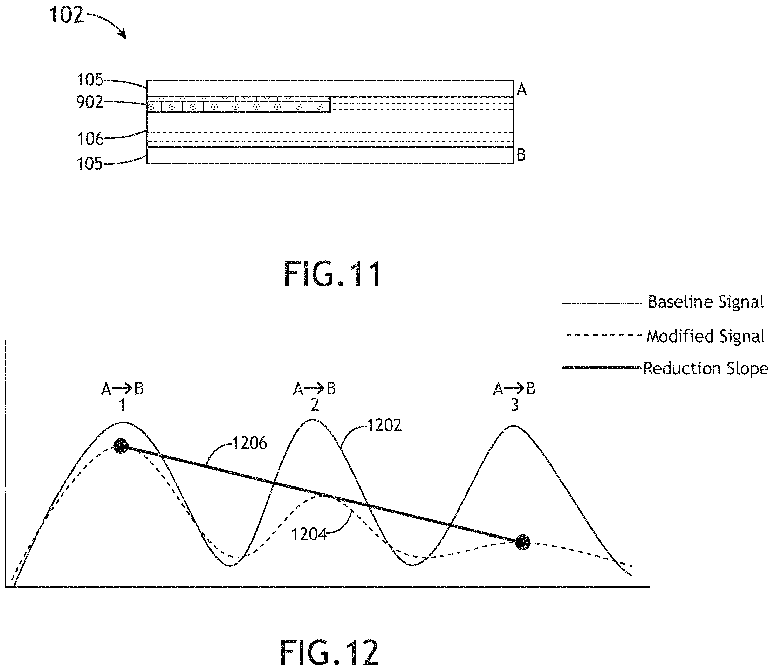

Referring now to FIG. 11, an exemplary embodiment of at least one memristor 102 according to the inventive concepts disclosed herein is depicted. The memristor 102 may be implemented similarly and function similarly to the memristor 102 of FIG. 9, except that the at least one permanent modification material 902 does not fully extend along the first plate 105 (A). For example, the memristor material 106 may abut a first surface area of the first conductive plate 105 (A). The memristor material 106 may abut a second surface area of the second conductive plate 105 (B). The first surface area and the second surface area may be different. The permanent signal modification may be a permanent asymmetric signal modification.

Referring now to FIG. 12, an exemplary graph of current versus time is shown. The graph shows a first curve 1202, a second curve 1204, and a reduction slope 1206. The first curve 1202 is associated with a baseline signal (e.g., an unmodified signal) before activation of the permanent modification material 902. The second curve 1204 is associated with a modified signal after activation of the permanent modification material 902.

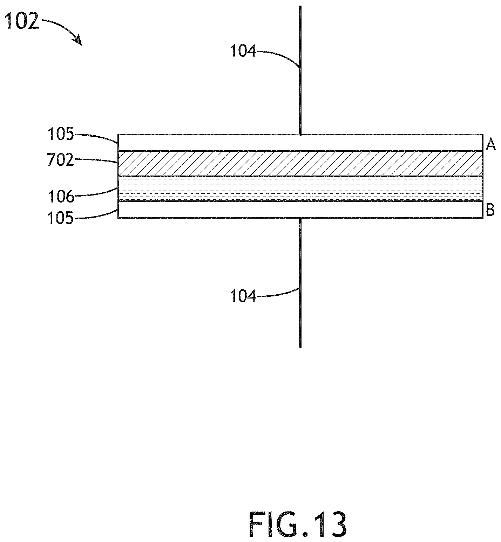

Referring now to FIG. 13, an exemplary embodiment of at least one memristor 102 according to the inventive concepts disclosed herein is depicted. The memristor 102 may be implemented similarly and function similarly to the memristor of FIG. 7, except that the memristor 102 may be a notch filter.

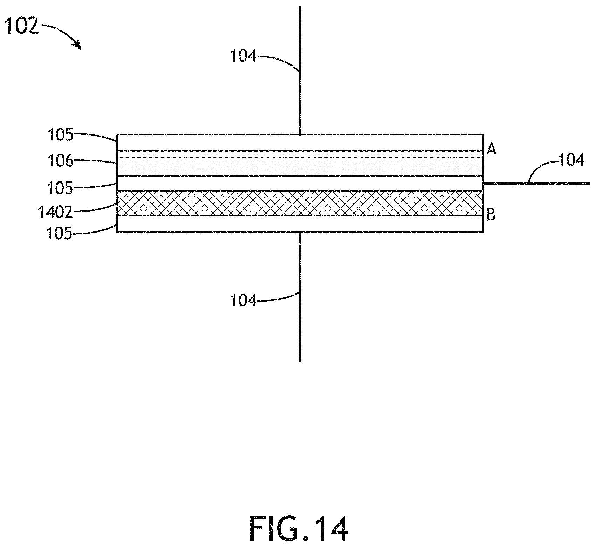

Referring now to FIG. 14, an exemplary embodiment of at least one device 102A according to the inventive concepts disclosed herein is depicted. The device 102A may be implemented similarly and function similarly to the memristor 102 of FIG. 7, except that the device 102A may further include at least one dielectric material 1402, a third conductive plate 105, and a third terminal 104.

The device 102A may include the first conductive plate 105, the second conductive plate 105, the memristor material 106, a third conductive plate 105, a dielectric material 1402, a first terminal 104 electrically coupled to the first conductive plate 105, a second terminal 104 electrically coupled to the second conductive plate 105, and a third terminal 104 electrically coupled to the third conductive plate 105. The dielectric material 1402 may be positioned between the second conductive plate 105 and the third conductive plate 105. The device 102A may have memristor functionality and capacitor functionality. The device 102 may be a bandpass filter, which for example, may be combined RC time constant.

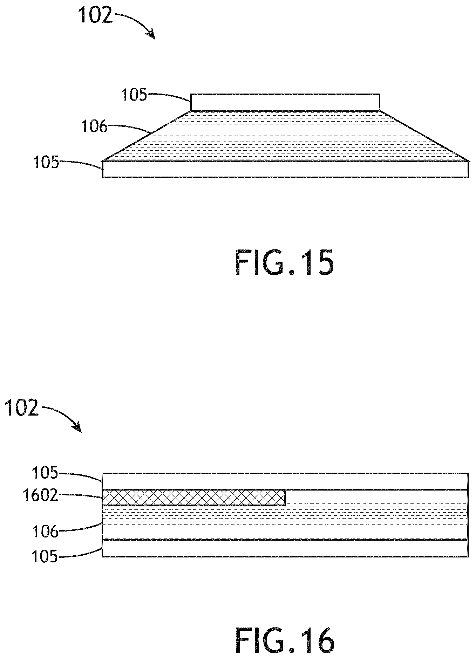

Referring now to FIGS. 15-16, exemplary embodiments of at least one memristor 102 according to the inventive concepts disclosed herein are depicted. The memristor 102 may be implemented similarly and function similarly to the memristor of FIG. 1A, except that in FIGS. 15-16: the memristor material 106 may abut a first surface area of the first conductive plate 105 (A); the memristor material 106 may abut a second surface area of the second conductive plate 105 (B); and the first surface area and the second surface area may be different (e.g., the first surface area may be less the second surface area as shown in FIGS. 15-16). In some embodiments, the memristor of FIGS. 15-16 may provide an asymmetric signal response. For example, the response can be modified to create greater oxygen vacancy density on the first conductive plate 105 (A) and lower density on the second conductive plate 105 (B). For example, such asymmetric application can be tailored by modification of a location and an amount of surface area covered by the blocking material 1602 (as shown in FIG. 16).

In some embodiments, the asymmetric response of the memristor 102 of FIGS. 15-16 can be used for: phase shifting an input signal (e.g., a digital clock phase shift); filtering by using only resistive elements; control system feedback; integrated analog compensation for undesired hysteresis effects (e.g., a lag in a temperature sensor reading versus actual instantaneous temperature) that can reduce or eliminate a need to compensate for such effects through software.

As shown in FIG. 15, opposing faces of the first and second conductive plates 105 may have different surface areas.

As shown in FIG. 16, the memristor 102 may further include a blocking material 1602. The blocking material 1602 may be positioned between the first conductive plate 105 and the second conductive plate 105. The blocking material 1602 may abut the memristor material 106 and one of the first conductive plate 105 or the second conductive plate 105.

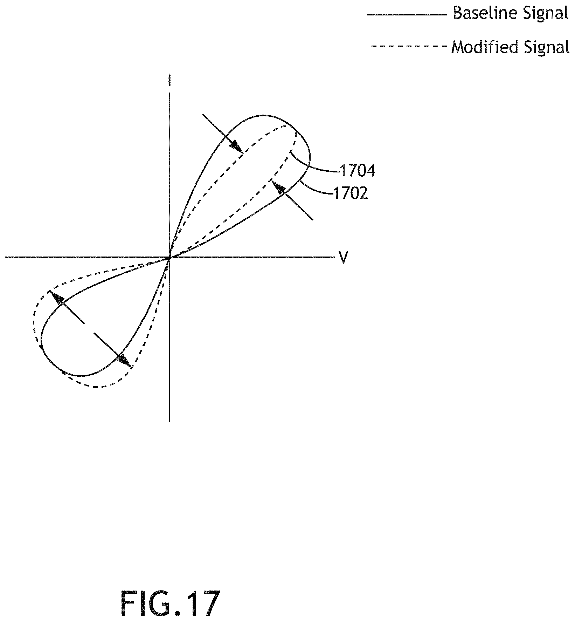

Referring now to FIG. 17, an exemplary graph of current (I) versus voltage (V) is shown. The graph shows a first I-V curve 1702 and a second I-V curve 1704. The first I-V curve 1702 is associated with a baseline signal (e.g., an unmodified signal) of a hypothetical memristor 102 with a first surface area of the first conductive plate 105 equal to the second surface area of the second conductive plate 105. The second I-V curve 1704 may be an I-V curve for the output signal of the memristor 102 of FIGS. 15-16.

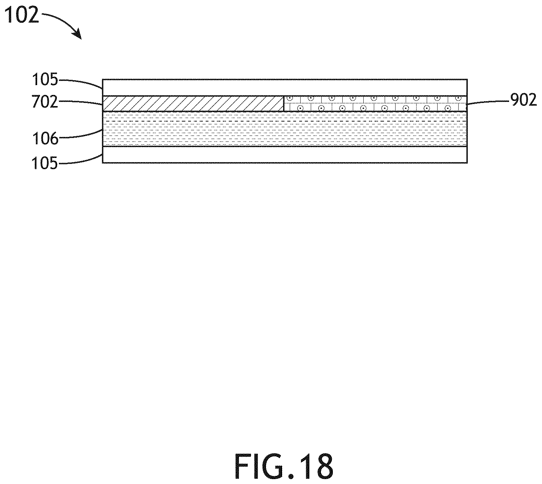

Referring now to FIG. 18, an exemplary embodiment of at least one memristor 102 according to the inventive concepts disclosed herein is depicted. The memristor 102 may be implemented similarly and function similarly to the memristor of FIG. 11, except that in FIG. 18: the memristor 102 includes a permanent modification material 902 and a transfer rate modification material 702; the permanent modification material 902 may be positioned between the first conductive plate 105 (A) and the second conductive plate 105 (B); the transfer rate modification material 702 may be positioned between the first conductive plate 105 (A) and the second conductive plate 105 (B); the permanent modification material 902 and the transfer rate modification material 702 may be in parallel electrically; at least a portion of the permanent modification material 902 may abut the memristor material 106; at least a portion of the transfer rate modification material 702 may abut the memristor material 106; a combination of the permanent modification material 902 and the transfer modification material 702 may provide a modification to the output signal after a signal is driven from the second conductive plate 105 (B) to the first conductive plate 105 (A).

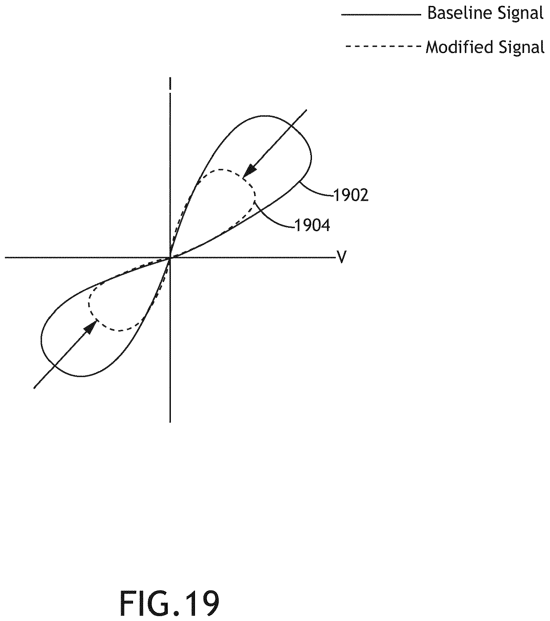

Referring now to FIG. 19, an exemplary graph of current (I) versus voltage (V) is shown. The graph shows a first I-V curve 1902 and a second I-V curve 1904. The first I-V curve 1902 is associated with a baseline signal (e.g., an unmodified signal) of a memristor 102 as shown in FIG. 1A. The second I-V curve 1904 may be an I-V curve for the output signal of the memristor 102 of FIG. 18.

In some embodiments, the system 100 may include a memristor network 114 having any combination of type and/or number of at least two memristors 102, such as shown in FIGS. 1A, 2, 3, 4, 7, 9, 11, 13, 14, 15, 16, and/or 18.

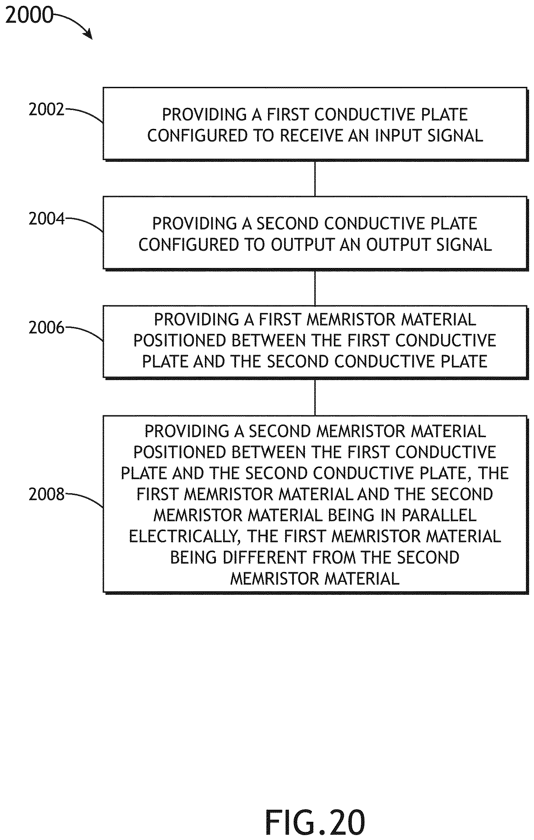

Referring now to FIG. 20, an exemplary embodiment of a method 2000 according to the inventive concepts disclosed herein may include one or more of the following steps. Additionally, for example, some embodiments may include performing one more instances of the method 2000 iteratively, concurrently, and/or sequentially. Additionally, for example, at least some of the steps of the method 2000 may be performed in parallel and/or concurrently. Additionally, in some embodiments, at least some of the steps of the method 2000 may be performed non-sequentially. Additionally, in some embodiments, at least some of the steps of the method 2000 may be performed in sub-steps of providing various components. In some embodiments, the method 2000 may be performed by a semiconductor fab tool(s).

A step 2002 may include providing a first conductive plate configured to receive an input signal.

A step 2004 may include providing a second conductive plate configured to output an output signal.

A step 2006 may include providing a first memristor material positioned between the first conductive plate and the second conductive plate.

A step 2008 may include providing a second memristor material positioned between the first conductive plate and the second conductive plate, the first memristor material and the second memristor material being in parallel electrically, the first memristor material being different from the second memristor material.

Further, the method 2000 may include any of the operations disclosed throughout.

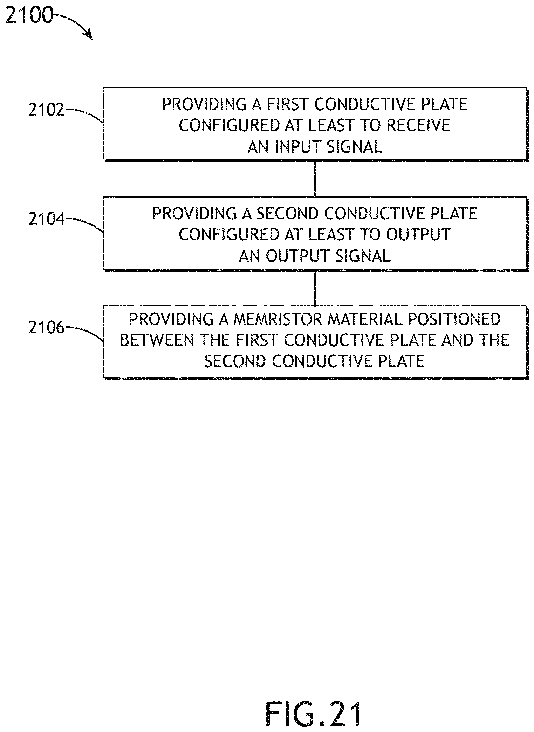

Referring now to FIG. 21, an exemplary embodiment of a method 2100 according to the inventive concepts disclosed herein may include one or more of the following steps. Additionally, for example, some embodiments may include performing one more instances of the method 2100 iteratively, concurrently, and/or sequentially. Additionally, for example, at least some of the steps of the method 2100 may be performed in parallel and/or concurrently. Additionally, in some embodiments, at least some of the steps of the method 2100 may be performed non-sequentially. Additionally, in some embodiments, at least some of the steps of the method 2100 may be performed in sub-steps of providing various components. In some embodiments, the method 2100 may be performed by a semiconductor fab tool(s).

A step 2102 may include providing a first conductive plate configured at least to receive an input signal.

A step 2104 may include providing a second conductive plate configured at least to output an output signal.

A step 2106 may include providing a memristor material positioned between the first conductive plate and the second conductive plate.

Further, the method 2100 may include any of the operations disclosed throughout.

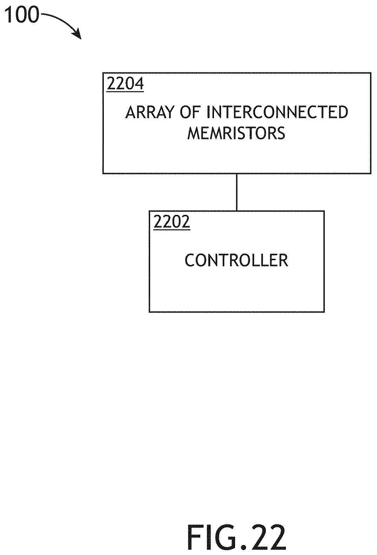

Referring now to FIGS. 22-28, further exemplary embodiments of the system 100 including an array of interconnected memristors 2204 according to the inventive concepts disclosed herein are depicted.

Referring now to FIG. 22, an exemplary embodiment of the system 100 according to the inventive concepts disclosed herein is depicted. The system 100 may include at least one memristor network 114 (e.g., at least one array of interconnected memristors 2204) and at least one controller 2202, which may be communicatively coupled. The array of interconnected memristors 2204 may include any or all of the elements and/or any or all of the arrangement of the elements described with respect to the memristor network 114 (e.g., including any of various embodiments of memristors 102), as disclosed throughout.

The at least one controller 2202 functions similarly to the processor 110. The at least one controller 2202 is configured to perform (e.g., collectively perform if more than one controller) any or all of the operations disclosed throughout. The controller 2202 may be configured to run various software and/or firmware applications and/or computer code stored (e.g., maintained) in a non-transitory computer-readable medium and configured to execute various instructions or operations. For example, the controller 2202 is configured to tune (e.g., set a state(s) of any or all of the memristors 102 of the array 2204 and/or read a state(s) of any or all of the memristors 102 of the array 2204) the array of interconnected memristors 2204.

In some embodiments, the array of interconnected memristors 2204 may have a customizable output response that may be pre-defined and/or controlled by the controller 2202. In some embodiments, controller 2202 may be configured to modify memristors 102 of the array of interconnected memristors 2204 at key interfaces such that the output response can be tailored electrical needs of a circuit. In some embodiments, the array of interconnected memristors 2204 may include a relatively large grid of memristors 102 or a smaller arrangement of memristors 102. In some embodiments, the array of interconnected memristors 2204 may be a tunable circuit and/or a tunable memristor based logic network through the use of additive or semi-additive processes. Some embodiments may include a closely integrated memristor logic network. Some embodiments may allow for elimination of the need of multiple discrete components and substrate carriers. Some embodiments may allow for additive construction of unique optimized circuit networks. Some embodiments may allow for size reduction of packaged circuit through thin vapor deposited memristor networks.

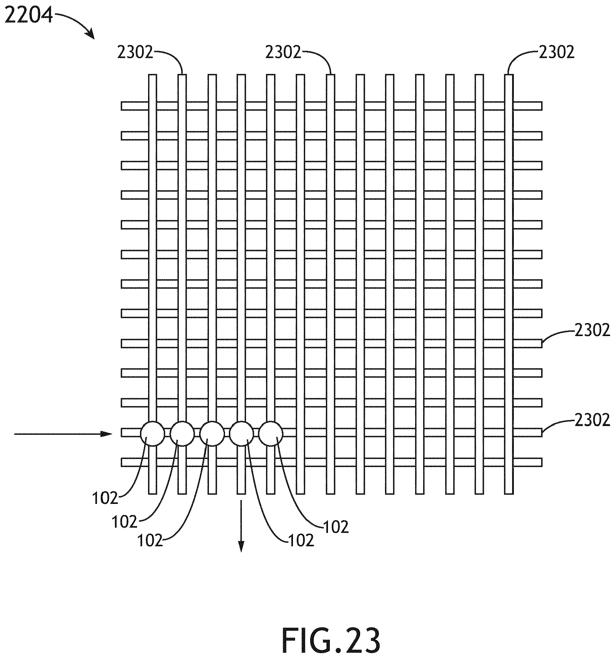

Referring now to FIGS. 23-26, exemplary embodiments of an array of interconnected memristors 2204 according to the inventive concepts disclosed herein are depicted. In some embodiments, the array of interconnected memristors 2204 may be one-dimensional (1D), two-dimensional (2D), 2.5-dimensional (2.5D), or three-dimensional (3D).

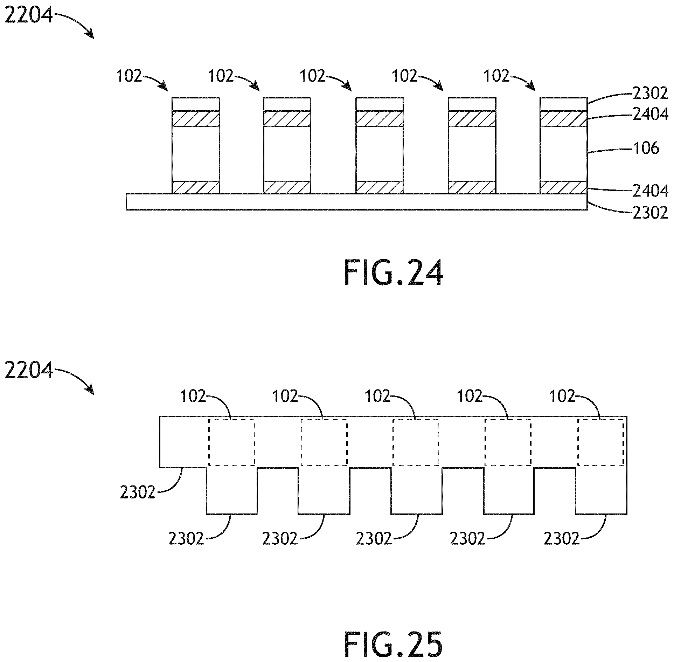

Referring now to FIG. 23, an exemplary embodiment of a 2D array of interconnected memristors 2204 according to the inventive concepts disclosed herein is depicted. The array of interconnected memristors 2204 may include memristors 102 and conductive paths 2302 (e.g., traces). Each memristor 102 of the array 2204 may be connected to a first particular conductive path 2302 at a first electrode (e.g., 2404, as shown in FIG. 24) and to a second particular conductive path 2302 at a second electrode (e.g., 2404, as shown in FIG. 24). Each of the conductive paths 2302 may be connected to the controller 2202. For example, the array of interconnected memristors 2204 may be an interconnected circuit lattice that has unique pre-defined and/or controlled random memristors 102 at connection interfaces. For example, the controller 2202 may be configured to change an order of activation of the array of interconnected memristors 2204 to output a unique response(s) based on the order of activation and/or based on which lead combination is selected through an initial activation phase and/or a secondary interaction(s). Any or all of the intersections of conductive paths 2302 may include a memristor 102 (e.g., a uniformly configured memristor or a unique memristor). For example, each memristor 102 of the array of interconnected memristors 2204 may have a same memristance value or a different memristance value as another memristor 102 of the array 2204. For example, the memristors 102 may have various memristor values selected specifically for an application or various values such that a broad range could be selected (e.g., similar to a decade box, except with memristors 102 rather than resistors). In some embodiments, the controller 2202 may be configured to electrically select which memristors 102 are being used in parallel or series and tune the circuit as needed.

Referring now to FIG. 24, a side view of an exemplary embodiment of a 1D or 2D array of interconnected memristors 2204 according to the inventive concepts disclosed herein is depicted. The array of interconnected memristors 2204 may include memristors 102, each coupled between two conductive paths 2302 (e.g., traces). Each memristor may include a first electrode 2404 (e.g., a conductive plate 105), a second electrode 2404 (e.g., a conductive plate 105), and at least one memristor material 106 positioned between the first electrode 2404 and the second electrode 2404.

In some embodiments, at least one first memristor material 106 of a first given memristor 102 of the array of interconnected memristors 2204 may include a first memristor material 106, at least one second memristor material 106 of a second given memristor 102 of the array of interconnected memristors 2204 may include a second memristor material 106, and the first memristor material 106 may be a same or different material from the second memristor material 106.

Referring now to FIG. 25, a top view of an exemplary embodiment of a 1D array of interconnected memristors 2204 according to the inventive concepts disclosed herein is depicted.

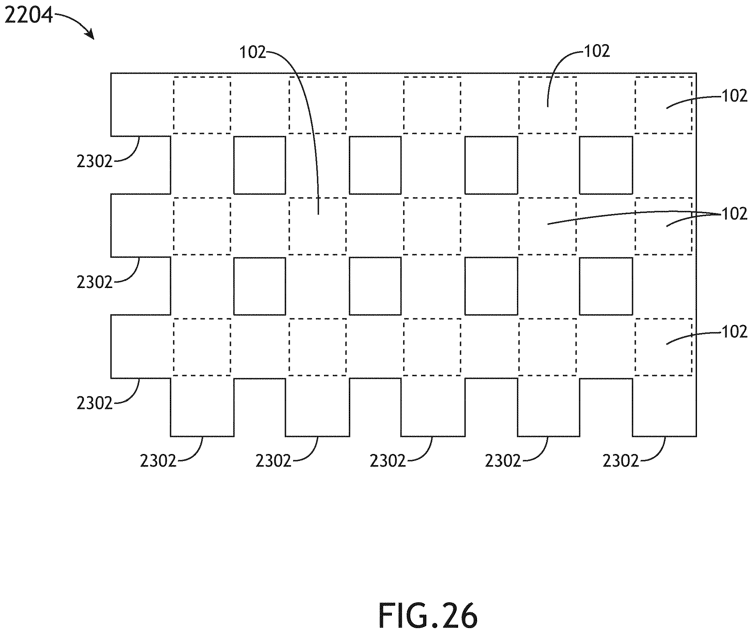

Referring now to FIG. 26, a top view of an exemplary embodiment of a 2D array of interconnected memristors 2204 according to the inventive concepts disclosed herein is depicted.

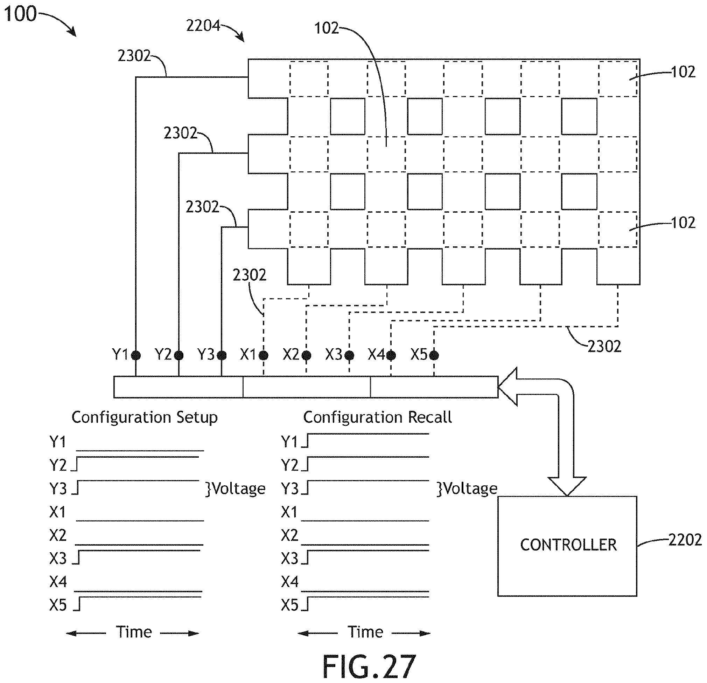

Referring now to FIG. 27, an exemplary embodiment of the system 100 according to the inventive concepts disclosed herein is depicted. The system 100 may include the array of interconnected memristors 2204 electrically coupled to the controller 2202. The controller 2202 may be configured to tune (e.g., set a state(s) of any or all of the memristors 102 of the array 2204 and/or read a state(s) of any or all of the memristors 102 of the array 2204) the array of interconnected memristors 2204. Setting a state(s) of any or all of the memristors 102 of the array 2204 may be referred to as configuration setup. Reading a state(s) of any or all of the memristors 102 of the array 2204 may be referred to as configuration recall.

For example, for configuration setup, the various memristors 102 of the array 2204 may be set to a state(s) by driving individual sets of one X and one Y conductive path 2302 to opposite voltages: e.g., X is high (Vdd) and Y is ground, or vice-versa. For example, the controller 2202 may apply the voltage to the memristor 102 long enough for all electrons to migrate to one side of the memristor 102 and until current has stopped flowing. The X-Y conductive paths 2302 may then be set to ground.

For example, for configuration recall, a memristor 102 of the array 2204 may be read by driving the Y conductive path high while driving the X conductive path low and checking for current flow. For example, if the memristor 102 had been set Y = high, X = low, then no current will flow as the same voltage is being applied as during the configuration setup process and all of the electrons will have already migrated. Likewise, for example, if the node had been set Y = low, X = high, then current flow will be high as the opposite voltage is being applied as during the configuration setup process and causing high electron migration. Note that during the configuration recall cycle, the Y conductive path 2302 may be driven high for a short time, such that there is not enough time for a significant quantity of electrons to migrate during the measurement cycle. Therefore, current flow may be high for a short duration of the configuration recall cycle.

For example, for a given memristor 102 of the array of interconnected memristors 2204, the controller 2202 is configured to set a state of the given memristor 102 by driving a voltage to one of the first conductive path 2302 and the second conductive path 2302 while the other of the first conductive path 2302 and the second conductive path 2302 is a ground. The controller 2202 is further configured to set the state of the given memristor 102 by applying the voltage to the one of the first conductive path 2302 and the second conductive path 2302 while the other of the first conductive path 2302 and the second conductive path 2302 is the ground until a steady state has been reached where electrons have migrated to one side of the at least one memristor material 106. Once the steady state is reached, the controller 2202 is further configured to set each of the first conductive path 2302 and the second conductive path 2302 to ground. For the given memristor 102 of the array of interconnected memristors 2204, the controller 2202 is configured to read the given memristor 102 by driving a voltage to the other of the first conductive path 2302 and the second conductive path 2302 while the one of the first conductive path 2302 and the second conductive path 2302 is a ground. In some embodiments, the controller 2202 is configured to set states of one, some, or all of the memristors 102 of the array of interconnected memristors 2204 and to read one, some, or all of the memristors 102 of the array of interconnected memristors 2204.

In some embodiments, the controller 2202 may be configured to customizably control an output response of the array of interconnected memristors 2204.

In some embodiments, the array of interconnected memristors 2204 may act as a tunable logic network.

According to the present invention, the controller 2202 is configured to tune the array of interconnected memristors 2204 such that the array of interconnected memristors 2204 acts as a selectable resistor network having differently sized resistors for test selecting the resistors to tune a mixed-signal integrated circuit.

In some embodiments, the array of interconnected memristors 2204 acts as a trimmer capacitor.

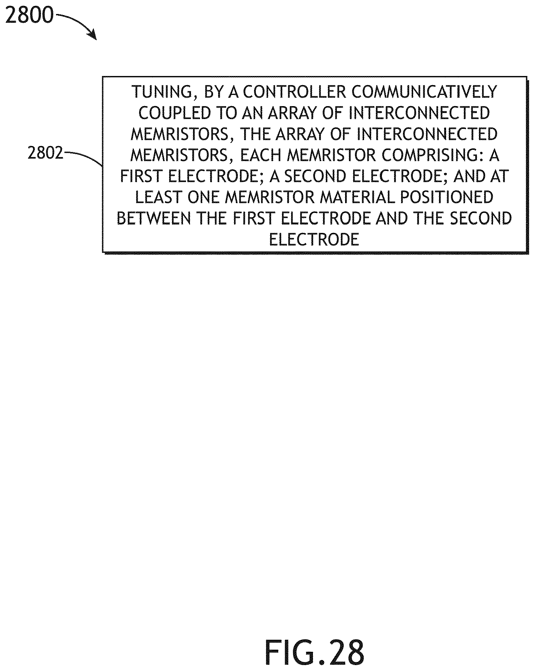

Referring now to FIG. 28, an exemplary embodiment of a method 2800 according to the inventive concepts disclosed herein may include one or more of the following steps. Additionally, for example, some embodiments may include performing one more instances of the method 2800 iteratively, concurrently, and/or sequentially. Additionally, for example, at least some of the steps of the method 2800 may be performed in parallel and/or concurrently. Additionally, in some embodiments, at least some of the steps of the method 2800 may be performed non-sequentially. Additionally, in some embodiments, at least some of the steps of the method 2800 may be performed in sub-steps of providing various components.

A step 2802 may include tuning, by a controller communicatively coupled to an array of interconnected memristors, the array of interconnected memristors, each memristor comprising: a first electrode; a second electrode; and at least one memristor material positioned between the first electrode and the second electrode.

Further, the method 2800 may include any of the operations disclosed throughout.

As will be appreciated from the above, embodiments of the inventive concepts disclosed herein may be directed to a method and a system including at least one device (e.g., at least one memristor) having at least one memristor material.

As used throughout and as would be appreciated by those skilled in the art, "at least one non-transitory computer-readable medium" may refer to as at least one non-transitory computer-readable medium (e.g., at least one memory device (e.g., a non-volatile memory device); e.g., at least one memristor; e.g., at least one computer-readable medium implemented as hardware; e.g., at least one non-transitory processor-readable medium, at least one memory (e.g., at least one nonvolatile memory, at least one volatile memory, or a combination thereof; e.g., at least one random-access memory, at least one flash memory, at least one read-only memory (ROM) (e.g., at least one electrically erasable programmable read-only memory (EEPROM)), at least one on-processor memory (e.g., at least one on-processor cache, at least one on-processor buffer, at least one on-processor flash memory, at least one on-processor EEPROM, or a combination thereof), or a combination thereof), at least one storage device (e.g., at least one hard-disk drive, at least one tape drive, at least one solid-state drive, at least one flash drive, at least one readable and/or writable disk of at least one optical drive configured to read from and/or write to the at least one readable and/or writable disk, or a combination thereof), or a combination thereof).

As used throughout, "at least one" means one or a plurality of; for example, "at least one" may comprise one, two, three, ..., one hundred, or more. Similarly, as used throughout, "one or more" means one or a plurality of; for example, "one or more" may comprise one, two, three, ..., one hundred, or more. Further, as used throughout, "zero or more" means zero, one, or a plurality of; for example, "zero or more" may comprise zero, one, two, three, ..., one hundred, or more.

In the present disclosure, the methods, operations, and/or functionality disclosed may be implemented as sets of instructions or software readable by a device. Further, it is understood that the specific order or hierarchy of steps in the methods, operations, and/or functionality disclosed are examples of exemplary approaches. Based upon design preferences, it is understood that the specific order or hierarchy of steps in the methods, operations, and/or functionality can be rearranged while remaining within the scope of the inventive concepts disclosed herein. The accompanying claims may present elements of the various steps in a sample order, and are not necessarily meant to be limited to the specific order or hierarchy presented.

It is to be understood that embodiments of the methods according to the inventive concepts disclosed herein may include one or more of the steps described herein. Further, such steps may be carried out in any desired order and two or more of the steps may be carried out simultaneously with one another. Two or more of the steps disclosed herein may be combined in a single step, and in some embodiments, one or more of the steps may be carried out as two or more sub-steps. Further, other steps or sub-steps may be carried in addition to, or as substitutes to one or more of the steps disclosed herein.

## Claims

1. A system (100), comprising:
an array of interconnected memristors (102, 2204), each memristor (102) comprising:
a first electrode (2404);
a second electrode (2404); and
at least one memristor material (106) positioned between the first electrode and the second electrode; and
a controller (110, 2202) communicatively coupled to the array of interconnected memristors (2204), wherein the controller is configured to tune the array of interconnected memristors;
wherein the array of interconnected memristors includes conductive paths such that each memristor of the array is connected to a first conductive path of the conductive paths at the first electrode and to a second conductive path of the conductive paths at the second electrode, wherein the conductive paths are further connected to the controller;
wherein, for a given memristor of the array of interconnected memristors, the controller is configured to set a state of the given memristor by driving a voltage to one of the first conductive path and the second conductive path while the other of the first conductive path and the second conductive path is a ground;
wherein the controller is further configured to set the state of the given memristor by applying the voltage to the one of the first conductive path and the second conductive path while the other of the first conductive path and the second conductive path is the ground until a steady state has been reached where electrons have migrated to one side of the at least one memristor material;
wherein, once the steady state is reached, the controller is further configured to set each of the first conductive path and the second conductive path to ground;
wherein, for the given memristor of the array of interconnected memristors, the controller is configured to read the given memristor by driving a voltage to the other of the first conductive path and the second conductive path while the one of the first conductive path and the second conductive path is a ground; **characterized in that**
the controller is configured to tune the array of interconnected memristors such that the array of interconnected memristors acts as a selectable resistor network having differently sized resistors for test selecting the resistors to tune a mixed-signal integrated circuit.

2. The system of claim 1, wherein at least one first memristor material of a first given memristor of the array of interconnected memristors includes a first memristor material, wherein at least one second memristor material of a second given memristor of the array of interconnected memristors includes a second memristor material, wherein the first memristor material is a same or different material from the second memristor material.

3. The system of claim 1, wherein the array of interconnected memristors is a one-dimensional array of interconnected memristors.

4. The system of claim 1, wherein the array of interconnected memristors is a two-dimensional array of interconnected memristors.

5. The system of claim 1, wherein the controller is configured to set states of all of the memristors of the array of interconnected memristors and to read all of the memristors of the array of interconnected memristors.

6. The system of claim 1, wherein the array of interconnected memristors is configured to act as a tunable logic network.

7. The system of claim 1, wherein the array of interconnected memristors is configured to act as a trimmer capacitor.

8. A method, comprising:
tuning, by a controller (110, 2202) communicatively coupled to an array of interconnected memristors (102, 2204), the array of interconnected memristors, each memristor comprising: a first electrode; a second electrode; and at least one memristor material (106) positioned between the first electrode (2404) and
the second electrode (2404), wherein the array of interconnected memristors includes conductive paths such that each memristor of the array is connected to a first conductive path of the conductive paths at the first electrode and to a second conductive path of the conductive paths at the second electrode, wherein the conductive paths are further connected to the controller;wherein, for a given memristor of the array of interconnected memristors, the controller is configured to set a state of the given memristor by driving a voltage to one of the first conductive path and the second conductive path while the other of the first conductive path and the second conductive path is a ground;wherein the controller is further configured to set the state of the given memristor by applying the voltage to the one of the first conductive path and the second conductive path while the other of the first conductive path and the second conductive path is the ground until a steady state has been reached where electrons have migrated to one side of the at least one memristor material;wherein, once the steady state is reached, the controller is further configured to set each of the first conductive path and the second conductive path to ground;wherein, for the given memristor of the array of interconnected memristors, the controller is configured to read the given memristor by driving a voltage to the other of the first conductive path and the second conductive path while the one of the first conductive path and the second conductive path is a ground and wherein the controller is configured to tune the array of interconnected memristors such that the array of interconnected memristors acts as a selectable resistor network having differently sized resistors for test selecting the resistors to tune a mixed-signal integrated circuit.

## Patentansprüche

1. System (100), das Folgendes umfasst:
eine Anordnung von miteinander verbundenen Memristoren (102, 2204), wobei jeder Memristor (102) Folgendes umfasst:
eine erste Elektrode (2404);
eine zweite Elektrode (2404); und
mindestens ein Memristor-Material (106), das zwischen der ersten Elektrode und der zweiten Elektrode positioniert ist; und
eine Steuerung (110, 2202), die kommunikativ an die Anordnung von miteinander verbundenen Memristoren (2204) gekoppelt ist, wobei
die Steuerung dazu konfiguriert ist, die Anordnung von miteinander verbundenen Memristoren abzustimmen;
wobei die Anordnung von miteinander verbundenen Memristoren leitende Pfade beinhaltet, sodass jeder Memristor der Anordnung mit einem ersten leitenden Pfad der leitenden Pfade an der ersten Elektrode und mit einem zweiten leitenden Pfad der leitenden Pfade an der zweiten Elektrode verbunden ist, wobei die leitenden Pfade ferner mit der Steuerung verbunden sind;
wobei die Steuerung für einen gegebenen Memristor der Anordnung von miteinander verbundenen Memristoren dazu konfiguriert ist, einen Zustand des gegebenen Memristors durch Ansteuern eines des ersten leitenden Pfads und des zweiten leitenden Pfads mit einer Spannung, während der andere des ersten leitenden Pfads und des zweiten leitenden Pfads eine Erdung ist, einzustellen;
wobei die Steuerung ferner dazu konfiguriert ist, den Zustand des gegebenen Memristors durch Anlegen der Spannung an den einen des ersten leitenden Pfads und des zweiten leitenden Pfads, während der andere des ersten leitenden Pfads und des zweiten leitenden Pfads die Erdung ist, einzustellen, bis ein stationärer Zustand erreicht ist, in dem Elektronen zu einer Seite des mindestens einen Memristor-Materials gewandert sind;
wobei, sobald der stationäre Zustand erreicht ist, die Steuerung ferner dazu konfiguriert ist, sowohl den ersten leitenden Pfad als auch den zweiten leitenden Pfad auf Erdung einzustellen;
wobei die Steuerung für den gegebenen Memristor der Anordnung von miteinander verbundenen Memristoren dazu konfiguriert ist, den gegebenen Memristor durch Ansteuern des anderen des ersten leitenden Pfads und des zweiten leitenden Pfads mit einer Spannung, während der eine des ersten leitenden Pfads und des zweiten leitenden Pfads eine Erdung ist, auszulesen; **dadurch gekennzeichnet, dass**
die Steuerung dazu konfiguriert ist, die Anordnung von miteinander verbundenen Memristoren derart abzustimmen, dass die Anordnung von miteinander verbundenen Memristoren als ein auswählbares Widerstandsnetzwerk mit unterschiedlich bemessenen Widerständen zur Testauswahl der Widerstände zum Abstimmen einer integrierten Mischsignal-Schaltung fungiert.

2. System nach Anspruch 1, wobei mindestens ein erstes Memristor-Material eines ersten gegebenen Memristors der Anordnung von miteinander verbundenen Memristoren ein erstes Memristor-Material beinhaltet, wobei mindestens ein zweites Memristor-Material eines zweiten gegebenen Memristors der Anordnung von miteinander verbundenen Memristoren ein zweites Memristor-Material beinhaltet, wobei das erste Memristor-Material dasselbe Material wie das zweite Memristor-Material ist oder sich von diesem unterscheidet.

3. System nach Anspruch 1, wobei die Anordnung von miteinander verbundenen Memristoren eine eindimensionale Anordnung von miteinander verbundenen Memristoren ist.

4. System nach Anspruch 1, wobei die Anordnung von miteinander verbundenen Memristoren eine zweidimensionale Anordnung von miteinander verbundenen Memristoren ist.

5. System nach Anspruch 1, wobei die Steuerung dazu konfiguriert ist, Zustände von allen Memristoren der Anordnung von miteinander verbundenen Memristoren einzustellen und alle Memristoren der Anordnung von miteinander verbundenen Memristoren auszulesen.

6. System nach Anspruch 1, wobei die Anordnung von miteinander verbundenen Memristoren dazu konfiguriert ist, als abstimmbares Logiknetzwerk zu fungieren.

7. System nach Anspruch 1, wobei die Anordnung von miteinander verbundenen Memristoren dazu konfiguriert ist, als Abgleichkondensator zu fungieren.

8. Verfahren, das Folgendes umfasst:
Abstimmen, durch eine Steuerung (110, 2202), die kommunikativ an eine Anordnung von miteinander verbundenen Memristoren (102, 2204) gekoppelt ist, der Anordnung von miteinander verbundenen Memristoren, wobei jeder Memristor Folgendes umfasst: eine erste Elektrode; eine zweite Elektrode; und mindestens ein Memristor-Material (106), das zwischen der ersten Elektrode (2404) und der zweiten Elektrode (2404) positioniert ist, wobei die Anordnung von miteinander verbundenen Memristoren leitende Pfade beinhaltet, sodass jeder Memristor der Anordnung mit einem ersten leitenden Pfad der leitenden Pfade an der ersten Elektrode und mit einem zweiten leitenden Pfad der leitenden Pfade an der zweiten Elektrode verbunden ist, wobei die leitenden Pfade ferner mit der Steuerung verbunden sind; wobei die Steuerung für einen gegebenen Memristor der Anordnung von miteinander verbundenen Memristoren dazu konfiguriert ist, einen Zustand des gegebenen Memristors durch Ansteuern eines des ersten leitenden Pfads und des zweiten leitenden Pfads mit einer Spannung, während der andere des ersten leitenden Pfads und des zweiten leitenden Pfads eine Erdung ist, einzustellen; wobei die Steuerung ferner dazu konfiguriert ist, den Zustand des gegebenen Memristors durch Anlegen der Spannung an den einen des ersten leitenden Pfads und des zweiten leitenden Pfads, während der andere des ersten leitenden Pfads und des zweiten leitenden Pfads die Erdung ist, einzustellen, bis ein stationärer Zustand erreicht ist, in dem Elektronen zu einer Seite des mindestens einen Memristor-Materials gewandert sind; wobei, sobald der stationäre Zustand erreicht ist, die Steuerung ferner dazu konfiguriert ist, sowohl den ersten leitenden Pfad als auch den zweiten leitenden Pfad auf Erdung einzustellen; wobei die Steuerung für den gegebenen Memristor der Anordnung von miteinander verbundenen Memristoren dazu konfiguriert ist, den gegebenen Memristor durch Ansteuern des anderen des ersten leitenden Pfads und des zweiten leitenden Pfads mit einer Spannung, während der eine des ersten leitenden Pfads und des zweiten leitenden Pfads eine Erdung ist, auszulesen, und wobei die Steuerung dazu konfiguriert ist, die Anordnung von miteinander verbundenen Memristoren derart abzustimmen, dass die Anordnung von miteinander verbundenen Memristoren als ein auswählbares Widerstandsnetzwerk mit unterschiedlich bemessenen Widerständen zur Testauswahl der Widerstände zum Abstimmen einer integrierten Mischsignal-Schaltung fungiert.

## Revendications

1. Système (100), comprenant :
un réseau de memristances interconnectées (102, 2204), chaque memristance (102) comprenant :
une première électrode (2404) ;
une seconde électrode (2404) ; et
au moins un matériau memristance (106) positionné entre la première électrode et la seconde électrode ; et
un dispositif de commande (110, 2202) couplé en communication au réseau de memristances interconnectées (2204), dans lequel le dispositif de commande est configuré pour régler le réseau de memristances interconnectées ;
dans lequel le réseau de memristances interconnectées comporte des chemins conducteurs de sorte que chaque memristance du réseau est connectée à un premier chemin conducteur des chemins conducteurs au niveau de la première électrode et à un second chemin conducteur des chemins conducteurs au niveau de la seconde électrode, dans lequel les chemins conducteurs sont également connectés au dispositif de commande ;
dans lequel, pour une memristance donnée du réseau de memristances interconnectées, le dispositif de commande est configuré pour définir un état de la memristance donnée en appliquant une tension à l'un du premier chemin conducteur et du second chemin conducteur tandis que l'autre du premier chemin conducteur et le second chemin conducteur est une masse ;
dans lequel le dispositif de commande est également configuré pour définir l'état de la memristance donnée en appliquant la tension à celui du premier chemin conducteur et du second chemin conducteur tandis que l'autre du premier chemin conducteur et du second chemin conducteur est la masse jusqu'à ce qu'un état stable soit atteint où les électrons ont migré vers un côté de l'au moins un matériau de memristance ;
dans lequel, une fois l'état stable atteint, le dispositif de commande est également configuré pour mettre chacun du premier chemin conducteur et du second chemin conducteur à la masse ;
dans lequel, pour la memristance donnée du réseau de memristances interconnectées, le dispositif de commande est configuré pour lire la memristance donnée en appliquant une tension à l'autre du premier chemin conducteur et du second chemin conducteur tandis que l'un du premier chemin conducteur et le second chemin conducteur est une masse ; **caractérisé en ce que**
le dispositif de commande est configuré pour régler le réseau de memristances interconnectées de sorte que le réseau de memristances interconnectées agit comme un réseau de résistances sélectionnables ayant des résistances de tailles différentes pour tester la sélection des résistances afin de régler un circuit intégré à signaux mixtes.

2. Système selon la revendication 1, dans lequel au moins un premier matériau de memristance d'une première memristance donnée du réseau de memristances interconnectées comporte un premier matériau de memristance, dans lequel au moins un second matériau de memristance d'une seconde memristance donnée du réseau de memristances interconnectées comporte un second matériau de memristance, dans lequel le premier matériau de memristance est un matériau identique ou différent du second matériau de memristance.

3. Système selon la revendication 1, dans lequel le réseau de memristances interconnectées est un réseau unidimensionnel de memristances interconnectées.

4. Système selon la revendication 1, dans lequel le réseau de memristances interconnectées est un réseau bidimensionnel de memristances interconnectées.

5. Système selon la revendication 1, dans lequel le dispositif de commande est configuré pour définir les états de toutes les memristances du réseau de memristances interconnectées et pour lire toutes les memristances du réseau de memristances interconnectées.

6. Système selon la revendication 1, dans lequel le réseau de memristances interconnectées est configuré pour agir comme un réseau logique réglable.

7. Système selon la revendication 1, dans lequel le réseau de memristances interconnectées est configuré pour agir comme un condensateur ajustable.

8. Procédé, comprenant :
le réglage, par un dispositif de commande (110, 2202) couplé en communication à un réseau de memristances interconnectées (102, 2204), du réseau de memristances interconnectées, chaque memristance comprenant : une première électrode ; une seconde électrode ; et au moins un matériau de memristance (106) positionné entre la première électrode (2404) et la seconde électrode (2404), dans lequel le réseau de memristances interconnectées comporte des chemins conducteurs de sorte que chaque memristance du réseau est connectée à un premier chemin conducteur des chemins conducteurs au niveau de la première électrode et à un second chemin conducteur des chemins conducteurs au niveau de la seconde électrode, dans lequel les chemins conducteurs sont également connectés au dispositif de commande ; dans lequel, pour une memristance donnée du réseau de memristances interconnectées, le dispositif de commande est configuré pour définir un état de la memristance donnée en appliquant une tension à l'un du premier chemin conducteur et du second chemin conducteur tandis que l'autre du premier chemin conducteur et du second chemin conducteur est une masse ; dans lequel le dispositif de commande est également configuré pour définir l'état de la memristance donnée en appliquant la tension à celui du premier chemin conducteur et du second chemin conducteur tandis que l'autre du premier chemin conducteur et du second chemin conducteur est la masse jusqu'à ce qu'un état stable soit atteint où les électrons ont migré vers un côté de l'au moins un matériau de memristance ; dans lequel, une fois l'état stable atteint, le dispositif de commande est également configuré pour mettre chacun du premier chemin conducteur et du second chemin conducteur à la masse ; dans lequel, pour la memristance donnée du réseau de memristances interconnectées, le dispositif de commande est configuré pour lire la memristance donnée en appliquant une tension à l'autre du premier chemin conducteur et du second chemin conducteur tandis que celui du premier chemin conducteur et du second chemin conducteur est une masse et dans lequel le dispositif de commande est configuré pour régler le réseau de memristances interconnectées de sorte que le réseau de memristances interconnectées agit comme un réseau de résistances sélectionnables ayant des résistances de tailles différentes pour tester la sélection des résistances afin de régler un circuit intégré à signaux mixtes.
